Europäisches Patentamt

European Patent Office

Office européen des brevets

(19)

(11) Veröffentlichungsnummer: **0 217 898**

**B1**

(12) **EUROPÄISCHE PATENTSCHRIFT**

(45) Veröffentlichungstag der Patentschrift: **06.02.91**

(21) Anmeldenummer: **86902394.5**

(22) Anmeldetag: **02.04.86**

(86) Internationale Anmeldenummer:
**PCT/EP86/00201**

(87) Internationale Veröffentlichungsnummer:
**WO 86/06235 23.10.86 Gazette 86/23**

(51) Int. Cl.⁵: **H 04 N 5/50,** H 03 J 5/02,
H 03 J 3/32

(54) **ABSTIMMSYSTEM FÜR FERNSEHGERÄTE.**

(30) Priorität: **11.04.85 DE 3512873**

(43) Veröffentlichungstag der Anmeldung:
**15.04.87 Patentblatt 87/16**

(45) Bekanntmachung des Hinweises auf die
Patenterteilung:
**06.02.91 Patentblatt 91/06**

(84) Benannte Vertragsstaaten:
**AT BE CH DE FR GB IT LI LU NL SE**

(56) Entgegenhaltungen:
**EP-A-0 109 661
US-A-4 334 323**

(73) Patentinhaber: **Deutsche Thomson-Brandt
GmbH
Hermann-Schwer-Strasse 3 Postfach 1307
D-7730 Villingen-Schwenningen (DE)**

(72) Erfinder: **MAIER, Gerhard
Reutestrasse 19
D-7735 Dauchingen (DE)**

EP 0 217 898 B1

## Beschreibung

Die Erfindung geht aus von einem automatisch arbeitenden Abgleichverfahren für den Tuner in einem Fernsehempfänger mit einer geregelten HF-Vorverstärkerstufe und einem Zwischenfrequenzverstärker mit einem in seiner Resonanzfrequenz während des automatischen Abgleichs umschaltbaren Referenzkreis auf eine Resonanzfrequenz, welche dem arithmetischen Mittelwert (36,15 MHz) zwischen Bildträgerzwischenfrequenz (38,9 MHz) und Tonträgerzwischenfrequenz (33,4 MHz) entspricht, wobei das Regelspannungsmaximum des Zwischenfrequenzverstärkers als Kriterium für einen optimalen Abgleich dient und während des automatischen Abgleichs ein Zusatzoszillator mit einer Hilfsfrequenz eingeschaltet wird, der über eine Mischstufe aus der Tuneroszillatorfrequenz $f_o$ eine dem arithmetischen Mittel aus Bildträgerfrequenz BT und Tonträgerfrequenz TT entsprechende Abgleichfrequenz erzeugt und der automatische Abgleich dadurch erfolgt, indem von einem Mikroprozessor gesteuert nacheinander in digitalen Schritten über Digital-Analog-Wandler Abstimmspannungswerte an die in den HF-Abstimmkreisen befindlichen Kapazitätsdioden gelegt werden und die Erhöhung der Abstimmspannungswerte bei Erreichen eines Regelspannungsmaximums unterbrochen wird und der ermittelte Abstimmspannungswert im angesteuerten Digital-Analog-Wandler festgehalten wird.

Eine Abstimmeinheit ist z.B. in der DE—A—28 54 852 beschrieben, die mittels dreier Hilfsoszillatoren und diesen zugeordneten Analogspeichern unter Verwendung der PLL-Schaltung die Hochfrequenzkreise auf die gewünschte Empfangsfrequenz abstimmen. Bei dieser Abstimmeinheit wird auch dabei der Tuneroszillator beim Abgleich herangezogen. Außerdem sind der Zahl der abzugleichenden Hochfrequenzkreise entsprechende Hilfsoszillatoren notwendig. Die Zahl der benötigten Hilfsoszillatoren und somit der Materialaufwand erhöht sich dann in besonderem Maße, wenn z.B. beim Abgleich eines Fernsehempfängers Band I, Band III und die Bänder IV und V abgeglichen werden sollen. Es besteht dabei die Gefahr von Mehrdeutigkeiten zwischen den Frequenzen des Tuneroszillators, der Hilfsoszillatoren und den Empfangsfrequenzen. Nachteilig für eine praktikable Realisierung der vorgeschlagenen Abstimmeinheiten ist, daß die Erregerwicklungen der Hilfsoszillatoren mit den einzelnen Spulen in den Hochfrequenzkreisen unerwünschte Resonanzen und Bedämpfungen der Kreise hervorrufen können, die auch noch eine unkontrollierbare Verstimmung der Kreise verursachen, wenn die Hilfsoszillatoren nach erfolgtem Abgleich abgeschaltet sind. Außerdem sind Analogspeicher vorgesehen, die in zeitlichen Abständen nachgeladen werden müssen, um die optimalen Abstimmwerte zu erhalten. Aus diesen Gründen ist prinzipbedingt ein optimaler Abgleich des Empfangsgerätes nicht erreichbar. Außerdem werden durch das sich laufend wiederholende Nachstimmen Störungen auf dem Bildschirm oder im Lautsprecher sichtbar bzw. hörbar.

In der Zeitschrift "Nachrichten elektronik" Heft 11/79, Seiten 365-368 wird ein Abstimmverfahren für Rundfunkempfänger beschrieben, das ebenfalls zusätzliche Hilfskreise in den Hochfrequenzfiltern anwendet. Auch hier ergeben sich nachteilige Beeinflussungen der Kreise im Betrieb des abgeglichenen Empfängers. Wie auf Seite 367 linke und mittlerer Spalte angegeben, wird die Genauigkeit der Abstimmungen durch Spezialbauteile nur in Form von exakt gepaarten Dioden erzielt. Auch dies fordert einen nicht außer acht zu lassenden Aufwand.

Es ist auch ein Testsystem für einen Empfänger bekannt (US—A—3,736,512), welches im On-line-Betrieb die Eigenschaften der einzelnen Stufen des Empfängers wie z.B. Vorverstärker, Mischstufe, ZF-Verstärker überprüft. Bei Abweichungen von den Sollwerten, die optisch angezeigt werden, müssen diese vom Bedienenden des Empfängers korrigiert werden. Es handelt sich nicht um ein in sich geschlossenes Abgleichsystem, bei welchem HF-Filterkreise automatisch für jeden Empfangskanal optimal abgeglichen werden.

Aus der EP—A—O 109 661 ist ein automatisch arbeitendes Abgleichverfahren bekannt, bei welchem als Kriterium für den Abgleich die demodulierte HF-Spannung dient, die am Ausgang einer HF-Verstärkerstufe oder Mischstufe entnommen wird. Es wird eine Hilfsfrequenz in den Antenneneingang eingespeist, wodurch jedoch besondere Vorkehrungen getroffen werden müssen, damit diese Hilfsfrequenz von der Antenne nicht abgestrahlt wird.

Der Erfindung liegt die Aufgabe zugrunde ein Abgleichverfahren zu schaffen, welches unter der Verwendung eines Hilfsoszillators von der Antenne des Fernsehempfängers vollkommen getrennt ist. Diese Aufgabe wird durch die im Patentanspruch angegebene Erfindung gelöst. Sie besitzt den Vorteil, daß hierdurch keine besonderen Vorkehrungen bezüglich Störstrahlung getroffen werden müssen und es gewährleistet ist, daß die Postvorschriften mit Sicherheit eingehalten werden.

Nachstehend wird das Wesentliche der Erfindung an einem Ausführungsbeispiel mit Hilfe der Zeichnung erläutert.

Figur 1 zeigt die Wesentlichen für das automatische Abgleichsystem erforderlichen Baugruppen in einem Blockschaltbild;

Figur 2 zeigt ein Diagramm zur Erläuterung der Wirkungsweise.

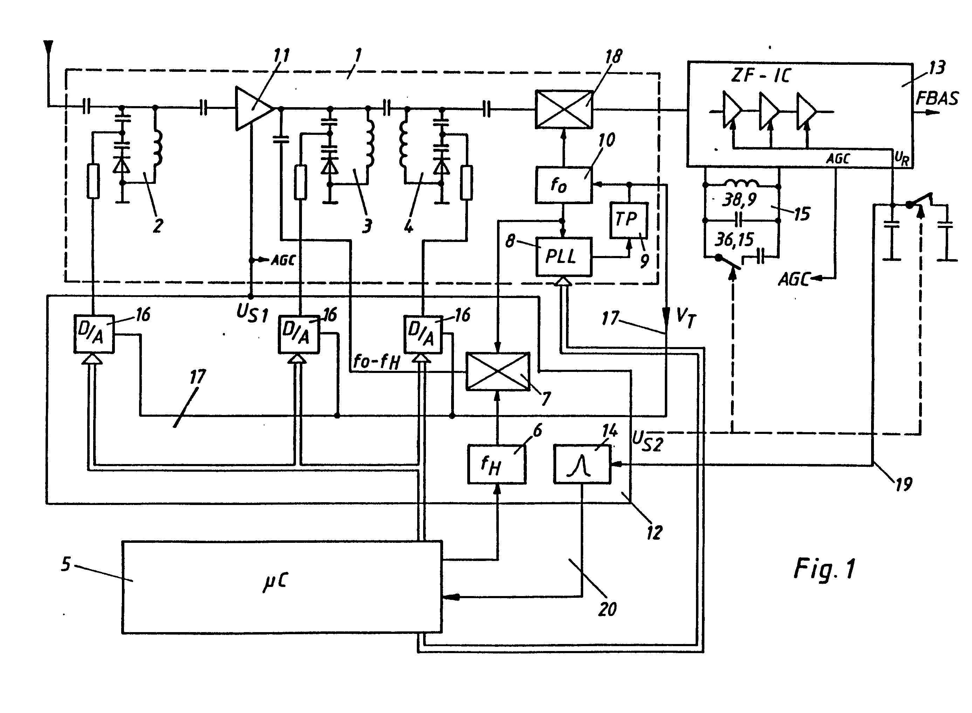

In Figur 1 ist ein Tuner eines Fernsehempfangsgerätes mit 1 bezeichnet, dessen HF-Filterkreise 2, 3, und 4 automatisch abgeglichen werden sollen, indem an die in diesen befindlichen Kapazitätsdioden entsprechende Abstimmgleichspannungen angelegt werden. Dazu wird vom Mikroprozessor 5 gesteuert ein Hilfsoszillator 6 mit einer Hilfsfrequenz fH eingeschaltet, die in einer Mischstufe 7 mit der eingestellten Oszillatorfrequenz fo des angewählten Kanals zu einer. Differenzfrequenz $f_o$ - $f_H$ gemischt wird Diese Differenzfrequenz wird mit der Oszillatorfrequenz $f_o$ in der Mischstufe 18 des Empfängers in eine Frequenzumgesetzt, die um den Betrag der Hilfsfrequenz $f_H$ im Zwischenfrequenzbereich unterhalb der Oszillatorfrequenz fo liegt, so daß die Mischstufe 18 z.B. eine Frequenz von 36,15 MHz erzeugt. Während des Abgleichs des Bandfilters 3, 4 wird der HF-Vorverstärker 11 durch Abregelung wirkungslos gemacht. Dies geschieht durch eine entsprechende Steuerspannung $U_{S1}$ aus der Steuerschaltung 12. Während des Abgleichs wird der Referenzkreis 15 des ZF-Bausteins 13 auf die Referenzfrequenz (36,15 MHz) mit $U_{S2}$ umgeschaltet. Außerdem wird der Kapazitätswert am Regelspannungs-Ausgang des ZF-Bausteins 13 und damit die Zeitkonstante durch Abschaltung eines Kondensators verkleinert. An dem $U_R$-Ausgang wird bei optimalem Abgleich ein Maximum einer Regelspannung festgestellt, welche über die Leitung 19 einer Auswerteschaltung 14 in der Steuerschaltung 12 zugeführt wird, die über eine Leitung 20 an den Mikroprozessor 5 die weitere schrittweise Änderung der Abstimmspannung unterbricht. Nach dem erfolgtem Abgleich des Bandfilters 3, 4 wird der Hilfsoszillator 6 abgeschaltet, die Vorverstärkerstufe 11 wieder voll aufgeregelt und die Frequenz des Tuneroszillators 10 um eine der halben Tonzwischenfrequenz (5,5 MHz) entsprechenden Wert heraufgesetzt.

Das bedeutet, daß bei der gewählten umgeschalteten Referenzfrequenz der Tonträger des Antennensignals als Hilfsfrequenz dient. Die sich einstellende Abstimmspannung des Tuneroszillators dient als Basisspannung für die Digital-Analog-Wandler 16, die diesen über die Leitung 17 zugeführt wird. Nach erfolgtem optimalem Abgleich wird der Tuneroszillator wieder auf die dem Kanal entsprechende Frequenz umgeschaltet, wodurch der Antennenkreis 2 auf Bandmitte abgestimmt ist.

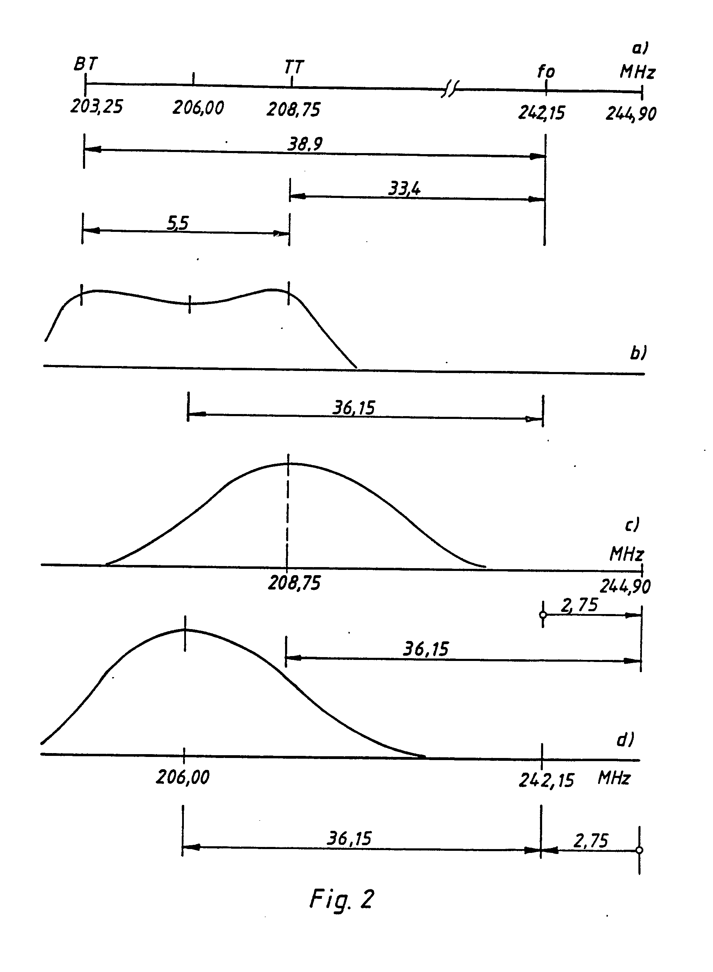

In Figur 2 ist ein Beispiel des automatischen Abgleichs für den Fernsehkanal 9 im Band III dargestellt. In diesem Kanal liegt der Bildträger bei 203,25 MHz, der Tonträger bei 208,75 MHz. Die einzustellende Tuneroszillatorfrequenz beträgt 242,15 MHz (Figur 2a). Die Mischstufe 7 liefert die Frequenz von 206 MHz, welche in Kanalmitte zwischen dem Bildträger und dem Tonträger liegt für den automatischen Abgleich des HF-Bandfilters 3, 4 unter Verwendung des Hilfsoszillators 6 (36,15 MHz).

Figur 2b zeigt die HF-Kurvencharakteristik für das Bandfilter 3, 4 nach dem Abgleich, woraufhin der Hilfsoszillator 6 abgeschaltet und der Tuneroszillator um 2,75 MHz höher eingestellt wird, d.h. auf 244,90 MHz. Da der Referenzkreis des ZF-Bausteins weiter auf der Resonanzfrequenz von 36,15 MHz liegt, wird nun der Antennenkreis 2 auf die Tonträgerfrequenz 208,75 MHz abgestimmt (Figur 2c). Nach dem Zurückschalten des Tuneroszillators 10 auf seine Sollfrequenz von 242,15 MHz liegt der Antennenkreis 2 genau auf 206 MHz. (Figur 2d).

## Bezugszeichenliste

1 Tuner
2 Filterkreis
3 Bandfilterkreis
4 Bandfilterkreis
5 Mikroprozessor
6 Hilfsoszillator
7 Mischstufe
8,9 PLL-Schleife
10 Tuneroszillator
11 HF-Vorverstärker
12 Steuerschaltung
13 ZF-Baustein
14 Auswerteschaltung
15 Referenzkreis
16 Digital-Analog-Wandler
17 Leitung
18 Mischstufe
19 Leitung
20 Leitung

## Patentansprüche

Automatisch arbeitendes Abgleichverfahren für einen Tuner in einem Fernsehempfänger mit einer geregelten HF-Vorverstärkerstufe 11 und einem Zwischenfrequenzverstärker 13 mit einem in seiner Resonanzfrequenz während des automatischen Abgleichs umschaltbaren Referenzkreis 15 auf eine Resonanzfrequenz, welche dem arithmetischen Mittelwert (36,15 MHz) zwischen Bildträgerzwischenfrequenz (38,9 MHz) und Tonträgerzwischenfrequenz (33,4 MHz) entspricht, wobei das Regelspannungsmaximum des Zwischenfrequenzverstärkers 13 als Kriterium für eine optimalen Abgleich dient und während des automatischen Abgleichs ein Zusatzoszillator 6 mit einer Hilfsfrequenz eingeschaltet wird, der über eine Mischstufe 7 aus der Tuneroszillatorfrequenz $f_o$ eine dem arithmetischen Mittel aus der Bildträgerfrequenz BT und der Tonträgerfrequenz TT entsprechende Abgleichfrequenz erzeugt und der automatisch Abgleich dadurch erfolgt, indem von einem Mikroprozessor 5 gesteuert nacheinander in digitalen Schritten über Digital-Analog-Wandler 16 Abstimmspannungswerte an die in den HF-Abstimmkreisen befindlichen Kapazitätsdioden gelegt werden und die Erhöhung der Abstimmspannungswerte bei Erreichen eines Regelspannungsmaximums unterbrochen wird und der so ermittelte Abstimmspannungswert im angesteuerten Digital-Analog-Wandler festgehalten wird,
gekennzeichnet durch folgende Verfahrensschritte:

a) Abregelung der Vorverstärkerstufe (11)

b) gleichzeitige Einspeisung einer durch Mischung der Tuneroszillatorfrequenz ($f_o$) mit der durch den Zusatzoszillator (6) erzeugten Hilfsfrequenz gewonnenen Differenzfrequenz ($f_o$-$f_H$) in den Hochpunkt des HF-Bandfilters (3, 4)

c) Abgleich des HF-Bandfilters (3, 4) auf die eingespeiste-Frequenz ($f_o$-$f_H$)

d) Abschalten des Zusatzoszillators (6) und

Aufregelung der HF-Vorverstärkerstufe (11)

e) Einstellen der Tuneroszillatorfrequenz (fo) auf einen um den halben arithmetischen Mittelwert aus Bildträgerzwischenfrequenz (BT) und Tonträgerzwischenfrequenz (TT) erhöhten Wert

f) Abgleich des Vorkreises (2) auf den Tonträger des angewählten Kanals

g) Nach erfolgtem Abgleich Zurückschalten des Tuneroszillators (10) auf die dem angewählten Kanal entsprechende Oszillatorfrequenz.

## Revendications

Procédé de réglage automatique pour un tuner logé dans un récepteur de télévision comprenant un étage préamplificateur accordé HF 11 et un amplificateur de fréquence intermédiaire 13 avec un circuit de référence 15 commutable dont la fréquence de résonance pendant le réglage automatique sur une fréquence de résonance correspond à la moyenne arithmétique (36,15 MHz) entre la fréquence intermédiaire de la porteuse-image (38,9 MHz) et la fréquence intermédiaire de la porteuse-son (33,4 MHz), la tension de réglage maximum de l'amplificateur de fréquence intermédiaire 13 servant de critère pour un réglage optimal, et un oscillateur complémentaire 6 avec une fréquence auxiliaire mis en circuit produisant à partir de la fréquence d'oscillateur de tuner $f_o$ par l'intermédiaire d'un étage mélangeur 7 une fréquence de réglage correspondant à la moyenne arithmétique de la fréquence de la porteuse-image BT et de la fréquence de la porteuse-son TT et le réglage automatique étant effectué par le fait que des tensions d'accord commandées par un microprocesseur 5 sont appliquées successivement par pas numériques aux diodes à capacité variable montés dans les circuits d'accord HF au moyen de convertisseurs numérique/analogique 16 et que l'élévation des tensions d'accord est interrompue lorsque la tension de réglage atteint une valeur maximale, la tension d'accord ainsi déterminée étant conservée dans le convertisseur numérique/analogique commandé, caractérisé par les étapes de procédé suivantes:

a) On rend inopérant l'étage préamplificateur (11),

b) On envoie simultanément une fréquence différentielle $(f_o\text{-}f_H)$ obtenue en mélangeant la fréquence de l'oscillateur de tuner $(f_o)$ avec la fréquence auxiliaire générée par l'oscillateur complémentaire (6), au point haut du filtre de bande HF (3, 4),

c) On règle le filtre de bande HF (3, 4) à la fréquence d'alimentation $(f_o\text{-}f_H)$,

d) On déconnecte l'oscillateur complémentaire (6) et on remet en service l'étage préamplificateur HF (11),

e) On ajuste la fréquence de l'oscillateur de tuner $(f_o)$ sur une valeur augmentée de la demi valeur moyenne arithmétique obtenue à partir de la fréquence intermédiaire de la porteuse-son (TT),

f) On règle le préfiltre (2) sur la porteuse-son du canal sélectionné,

g) après le réglage, on recommute l'oscillateur de tuner (10) sur la fréquence de l'oscillateur correspondant au canal sélectionné.

## Claim

An automatically operating adjustment method for a tuner in a television receiver with a controlled HF pre-amplifier stage 11 and an intermediate frequency amplifier 13 with a reference circuit 15 switchable in resonance frequency during automatic adjustment to a resonance frequency which corresponds to the arithmetic mean value (36.15 MHz) between the picture carrier intermediate frequency (38.9 MHz) and the sound carrier intermediate frequency (33.4 MHz), in which the regulating voltage maximum of the intermediate frequency amplifier 13 serves as the criterion for optimum adjustment and during automatic adjustment an additional oscillator 6 with an auxiliary frequency is switched on, said additional oscillator by means of a mixing stage 7 producing from the tuner oscillator frequency $f_o$ an adjustment frequency corresponding to the arithmetic mean of the picture carrier frequency BT and the sound carrier frequency TT and the automatic adjustment is achieved by applying tuning voltage values to the capacitance diodes located in the HF tuning circuits, controlled by a microprocessor 5 successively in digital steps via digital/analogue converters 16, and the increase in the tuning voltage values is interrupted when a regulating voltage maximum is achieved and the tuning voltage value thus ascertained is held in the driven digital/analogue converter, characterised by the following method steps:

a) controlling down the pre-amplifier stage (11)

b) simultaneously feeding a difference frequency $(f_o\text{-}f_H)$, which is obtained by mixing the tuner oscillator frequency $(f_o)$ with the auxiliary frequency produced by the additional oscillator (6), into the high point of the HF band filter (3,4)

c) adjusting the HF band filter (3, 4) to the frequency $(f_o\text{-}f_H)$ as fed in

d) switching off the additional oscillator (6) and controlling up the HF pre-amplifier stage (11)

e) setting the tuner oscillator frequency $(f_o)$ to a value which is increased by half the arithmetic mean value of the picture carrier intermediate frequency (BT) and the sound carrier intermediate frequency (TT)

f) adjusting the initial circuit (2) to the sound carrier of the selected channel

g) once adjustment has taken place switching back the tuner oscillator (10) to the oscillator frequency which corresponds to the selected channel.

Fig. 1

Fig. 2